# EUROPEAN PATENT SPECIFICATION

(11) **EP 2 981 162 B1**
(45) Date of publication and mention of the grant of the patent: **24.04.2019**
(21) Application number: 13880057.8
(22) Date of filing: 29.03.2013
(51) Int. Cl.: G01B 11/02, H05K 13/04, H05K 13/08

(54) **MANUFACTURING EQUIPMENT**
PRODUKTIONSAUSRÜSTUNG
EQUIPEMENT DE PRODUCTION

(43) Date of publication of application: 03.02.2016
(73) Proprietor: FUJI Corporation, Chiryu Aichi (JP)
(72) Inventor: JINDO Takahiro, Chiryu Aichi (JP)
(74) Representative: Grünecker Patent- und Rechtsanwälte PartG mbB
(86) International application number: PCT/JP2013/059484
(87) International publication number: WO 2014/155658

(56) References cited:
- EP-A2- 1 986 483
- JP-A- H05 223 565
- JP-A- H10 260 016
- JP-A- 2003 279 307
- JP-A- 2004 071 641
- JP-A- 2007 115 820
- JP-A- 2011 066 041
- US-B1- 6 435 808
- US-B1- 8 213 022

## Description

### Technical Field

The present invention relates to a manufacturing equipment that is used to manufacture various products.

### Background Art

PTL 1 discloses a component mounting machine as a manufacturing equipment which mounts electronic components on a printed circuit board. This manufacturing equipment is required to control mechanical manufacturing operations with high accuracy so as to improve the quality of a product. For example, in the component mounting machine, the deformation state of the printed circuit board which is a manufacturing material, variations in the supply position of the electronic component, or the like, affect the accuracy of the control of mounting operations. The component mounting machine disclosed in PTL 1 is configured to measure the height of the printed circuit board or the electronic component using a sensor such as a laser distance meter. The measurement result is reflected in the control of the mounting operations, and thus accuracy is improved.

Furthermore, document US 6435808 B1 discloses a chip mounting apparatus capable of permitting a chip mounting operation to be executed at an increased speed and ensuring continuous running of the apparatus over a long period of time. The apparatus includes a chip observing camera mounted on the side of a chip mounting head, a lighting unit mounted on the side of the chip mounting head to light a background of a chip hold on a chip suction nozzle of the head, a reflection unit mounted on the side of the chip mounting head to input an image of the chip to the chip observing camera, feeder and stocker sections each adapted to replaceably held a chip storage package therein, and a package replacement mechanism for carrying out replacement of the chip storage package between both sections.

### Citation List

### Patent Literature

PTL 1: JP-A-2004-071641

### Summary of Invention

### Technical Problem

The additional installation of a sensor or the like in the manufacturing equipment is required so as to measure the distance to a target object. There is limitation to the installation of a device such as a sensor due to a demand for the reduction of the size of a manufacturing equipment.

The invention is made in light of this problem, and an object of the invention is to provide a manufacturing equipment that is configured to be able to improve the accuracy of the control of mechanical operations by measuring the distance to a target object unlike that in the related art.

### Solution to Problem

A manufacturing equipment according to independent claim 1.

In this configuration, it is possible to measure the distance between the target object and the camera using the camera that images a material so as to read information on a manufacturing material. That is, it is possible to use the camera which is already built in, and thus it is possible to measure the distance to the target object so as to be able to be used in the control of mechanical operations without additionally installing a device such as a sensor. Accordingly, it is possible to improve the accuracy of the control of mechanical operations.

### Brief Description of Drawings

Fig. 1 is a view illustrating the entirety of a component mounting machine (manufacturing equipment) in an embodiment.
Fig. 2 is a block diagram illustrating a printed circuit board camera and a control device of the component mounting machine.
Fig. 3 is a plan view illustrating the configuration of a liquid-crystal lens of the printed circuit board camera.
Fig. 4 is a distance table regarding lens characteristics of the liquid-crystal lens.
Fig. 5 is a view illustrating the measurement of distances using the printed circuit board camera, and the deformation state of the printed circuit board.
Fig. 6 is a view illustrating the height of a component held in each feeder of a component supply device.

### Description of Embodiments

### <Embodiment>

Hereinafter, an embodiment of a manufacturing equipment of the invention is described with reference to the accompanying drawings. In the embodiment, a component mounting machine is exemplified as the manufacturing equipment. For example, the component mounting machine is an apparatus that disposes (mount) a plurality of electronic components on a circuit board in an integrated circuit manufacturing process. The mounting regions of the electronic components on the circuit substrate are coated with cream solder using a screen printer, or the like, the circuit board is transported to a plurality of the component mounting machines in sequence, and the electronic components are mounted on the circuit substrate. Thereafter, the circuit substrate having the electronic components thereon is transported to a reflow furnace, and then the electronic components are soldered to the circuit substrate. As a result, the resultant circuit board forms an integrated circuit as a circuit printed circuit board product. The circuit board, the electronic components, and the cream solder are equivalent to manufacturing materials from the view point of the component mounting machine which is a manufacturing equipment.

### (Entire Configuration of Component Mounting Machine)

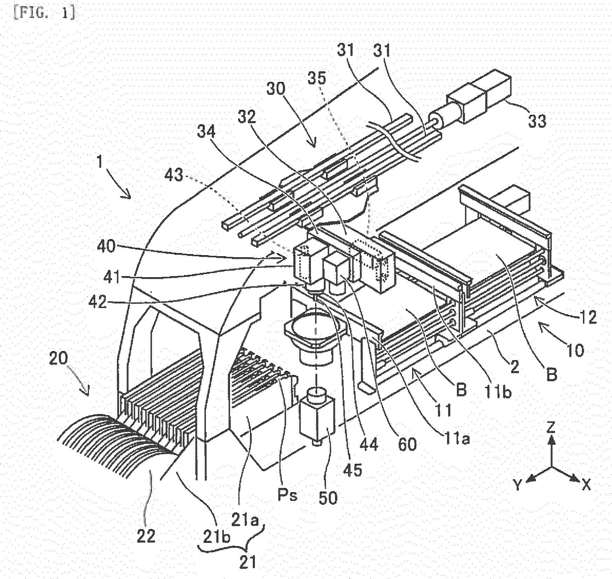

A component mounting machine 1 is configured to include a board conveyance device 10; a component supply device 20; a component transfer device 30; a component camera 50; a printed circuit board camera 60, and a control device 70. The devices 10, 20, and 30, and the cameras 50 and 60 are provided on a base 2 of the component mounting machine 1, and are controlled by the control device 70. As illustrated in Fig. 1, a horizontal lateral direction (a direction running from the upper left toward to the lower right in Fig. 1) of the component mounting machine 1 represents an X-axis direction, a horizontal longitudinal direction (a direction running from the upper right to the lower left in Fig. 1) of the component mounting machine 1 represents a Y-axis direction, and a height direction (a vertical direction in Fig. 1) represents a Z-axis direction.

The board conveyance device 10 transports the circuit board B in the X-axis direction of the component mounting machine 1, and also serves as a printed circuit board holding device that positions and holds the circuit board B at a predetermined position. The board conveyance device 10 is a double conveyor device configured to include a first transport mechanism 11 and a second transport mechanism 12 which are provided side by side in the Y-axis direction of the component mounting machine 1. The first transport mechanism 11 is configured to include a pair of guide rails 11a and 11b, a conveyor belt (not illustrated), and the like.

The pair of guide rails 11a and 11b of the first transport mechanism 11 is disposed above the base 2 while being parallel to each other in the X-axis direction, and guides the circuit board B that is transported by the conveyor belt while being placed thereon. A clamp device is provided in the first transport mechanism 11, and positions the circuit board B by pushing the circuit board B (which has been transported to a predetermined position) upwards from the base 2, and clamping the circuit board B. Since the second transport mechanism 12 is configured similar to the first transport mechanism 11, a detailed description thereof will be omitted.

The component supply device 20 supplies electronic components to be mounted on the circuit board B. The component supply device 20 is disposed on the front side (left front side in Fig. 1) in the Y-axis direction of the component mounting machine 1. In the embodiment, the component supply device 20 is a feeder device that is made up of a plurality of cassette type feeders 21. Each of the feeders 21 has a feeder main body 21a that is detachably attached to the base 2, and a reel accommodation portion 21b that is provided at a rear end of the feeder main body 21a. The reel accommodation portion 21b of the feeder 21 holds a supply reel 22 around which component packaging tape is wrapped.

The component packaging tape is configured to include carrier tape on which electronic components are accommodated at predetermined pitches, and top tape that covers the electronic components adhering to the upper surface of the carrier tape. The component packaging tape leading from the supply reel 22 is fed in a pitch by a pitch feed mechanism (not illustrated) of the feeder 21. The feeder 21 exposes the electronic components by peeling the top tape off from the carrier tape. The feeder 21 supplies the electronic components so that the component transfer device 30 can suction the electronic components at a component supply position Ps which is present at a front end of the feeder main body 21a.

The component transfer device 30 transfers each of the electronic components from the component supply position Ps to a mounting position on the circuit board B. In the embodiment, the component transfer device 30 is a Cartesian coordinate device that is disposed above the board conveyance device 10 and the component supply device 20. The component transfer device 30 includes a Y-axis moving carriage 32 which is provided on a pair of Y-axis rails 31a and 31b extending in the Y-axis direction in such a way to be able to move in the Y-axis direction. The Y-axis moving carriage 32 is controlled via a ball screw mechanism by the operation of a Y-axis servo motor 33. An X-axis moving carriage 34 is provided on the Y-axis moving carriage 32 in such a way to be able to move the X-axis direction. The X-axis moving carriage 34 is controlled via a ball screw mechanism (not illustrated) by the operation of an X-axis servo motor 35.

A head holding device 40 is attached to the X-axis moving carriage 34 of the component transfer device 30. The head holding device 40 has a case 41 fixed to the X-axis moving carriage 34, and supports an upward and downward moving shaft 42 in such a way that the upward and downward moving shaft 42 can move upwards and downwards relative to the case 41 in the Z-axis direction. The movement of the upward and downward moving shaft 42 in the Z-axis direction is controlled by the operation of a Z-axis servo motor 43 that is accommodated in the case 41. A mounting head 44 is exchangeably attached to a lower end portion of the upward and downward moving shaft 42.

The mounting head 44 holds a suction nozzle 45 (which suctions the electronic component supplied by the component supply device 20) in such a way that the suction nozzle 45 can rotate around a rotational axis that is parallel to the Z-axis of the component mounting machine 1. The rotation angle of the suction nozzle 45 relative to the mounting head 44 is controlled by the operation of a 9-axis servo motor 46 that is accommodated in the case 41. The suction nozzle 45 is a part of a suction mechanism (not illustrated) of the head holding device 40, and can suction the electronic component using negative controlled air pressure.

The component camera 50 and the printed circuit board camera 60 are digital cameras with an imaging element such as a charge coupled device (CCD) or a complementary metal oxide semiconductor (CMOS) . Each of the component camera 50 and the printed circuit board camera 60 performs imaging of a visual field range based on a control signal from the control device 70 that is communicatively connected to the component camera 50 and the printed circuit board camera 60, and transmits image data (which is acquired from the imaging operation) to the control device 70. The "visual field" of each of the component camera 50 and the printed circuit board camera 60 refers to an imaging range that is determined by a lens unit or an imaging element of each of the cameras 50 and 60.

The component camera 50 is fixed to the base 2 in such a way that the optical axis of the component camera 50 is aligned with the Z-axis direction, and is configured to be able to image the electronic component that is suctioned by the suction nozzle 45. The control device 70 processes the image data acquired by the component camera 50, and thus, recognizes the state of the electronic component being suctioned by the suction nozzle 45. The control device 70 improves the accuracy of the control of mounting operations by correcting the position and the angle of the suction nozzle 45 based on the suction state.

The printed circuit board camera 60 is fixed to the X-axis moving carriage 34 in such a way that the optical axis of the printed circuit board camera 60 is aligned with the Z-axis direction, and is configured to be able to image the circuit board B. More specifically, the printed circuit board camera 60 images a board mark (which is also referred to as a fiducial mark) on the circuit board B that is transported to a predetermined position by the board conveyance device 10. The control device 70 acquires image data from the imaging operation of the printed circuit board camera 60, and recognizes the position of the board mark contained in the image by processing the image data. The control device 70 controls such that the position of each of the Y-axis moving carriage 32 and the X-axis moving carriage 34 is corrected based on the actual position of the board mark and then mounting operations are performed. As such, the control device 70 improves the accuracy of the control of the mounting operations by using information (information regarding the position of the circuit board B) that is contained in the image acquired from the imaging operation of the printed circuit board camera 60.

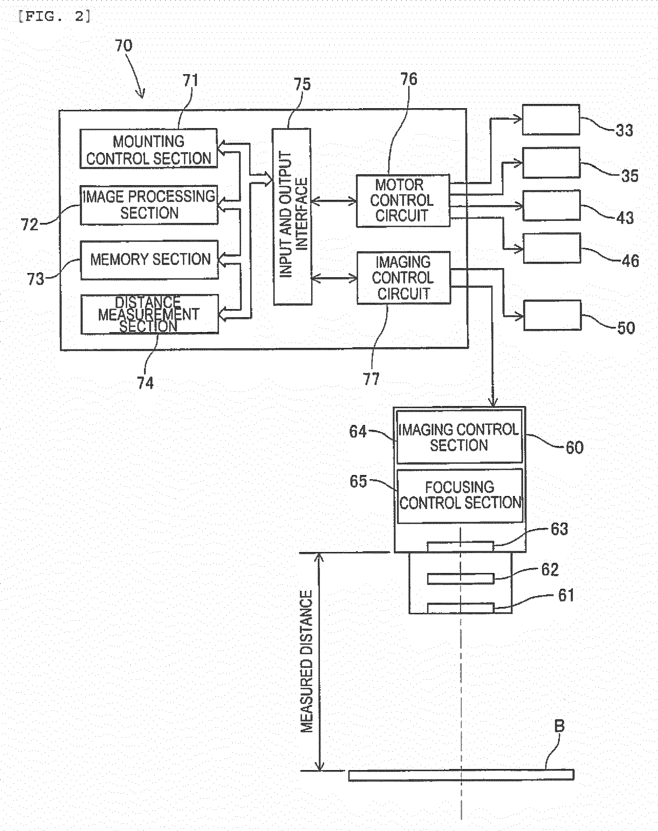

In the embodiment, the printed circuit board camera 60 also serves as a camera that is used to measure the distance to a target object such as the circuit board B or the electronic component. Specifically, the component mounting machine 1 uses the printed circuit board camera 60 in measuring the distance to a target object using a control value for the operation control of a varifocal lens included in the lens unit, in addition to imaging the circuit board B. As illustrated in Fig. 2, the printed circuit board camera 60 has a fixed lens 61; a liquid-crystal lens 62 (which is equivalent to the "varifocal lens" in the invention) ; an imaging element 63; an imaging control section 64; and a focusing control section 65. The fixed lens 61 and the liquid-crystal lens 62 are coaxially disposed with the optical axis of the imaging element 63. The fixed lens 61 is an objective lens that is disposed in the outermost portion of the lens unit, and has a function of preventing foreign matter from entering into the inside of the unit.

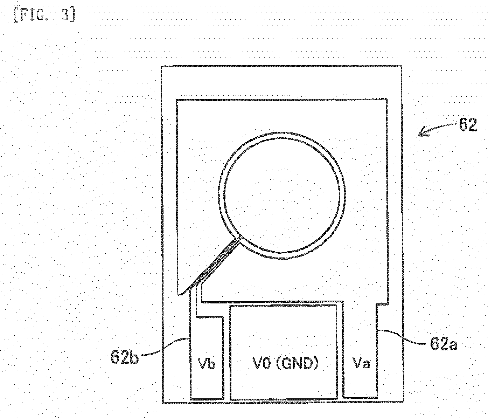

The liquid-crystal lens 62 is a varifocal lens that can change focal length corresponding to a voltage applied thereto. In the embodiment, a liquid-crystal lens with a configuration in which a liquid crystal layer is disposed between two electrodes is adopted as the varifocal lens. Specifically, as illustrated in Fig. 3, the liquid-crystal lens 62 has a first electrode 61a with a rectangular external shape, and a second electrode 61b with a circular shape. Each of the first electrode 61a and the second electrode 61b has two electrodes provided in a pair of transparent printed circuit boards which are disposed in parallel with each other, and the same liquid crystal layer is interposed between the two electrodes.

When different voltages are respectively applied to the first electrode 61a and the second electrode 61b, the orientation state of liquid crystal molecules is changed corresponding to the direction of electric field such that the liquid-crystal lens 62 with this configuration acts as a lens. When a voltage Va applied to the first electrode 61a is set to be higher than a voltage Vb applied to the second electrode 61b (Va < Vb), the liquid-crystal lens 62 serves substantially as a convex lens. When the amplitude of each of the applied voltages Va and Vb is set to be constant, it is possible to control the focal length of the liquid-crystal lens 62 using the difference between the applied voltages Va and Vb.

Light transmitted through the fixed lens 61 and the liquid-crystal lens 62 is converted into an electric signal by the imaging element 63. The imaging control section 64 images a subject by controlling the lens unit via the focusing control section 65 based on a control signal input from the outside, a set value stored in a memory (not illustrated), and the like, and converting the electric signal (which are converted by the imaging element 63) into a digital signal. An image acquired from the imaging operation is transmitted to the control device 70 from the imaging control section 64.

When the imaging control section 64 controls the lens unit, the focusing control section 65 brings the liquid-crystal lens 62 into focus based on the electric signal from the imaging element 63. Specifically, the focusing control section 65 determines whether the lens unit is in focus by performing image processing of the digital signal converted by the imaging control section 64. When the lens unit is not in focus, the focusing control section 65 brings the lens unit into focus by adjusting the applied voltage that is a control value for the operation control of the liquid-crystal lens 62, and changing the focal length of the liquid-crystal lens 62.

In the embodiment, the focusing control section 65 uses a contrast detection method in the image processing. That is, the focusing control section 65 determines whether the lens unit is in focus, based on contrast values calculated for a single predetermined region or a plurality of predetermined regions on the image. The focusing control section 65 is configured to boost or lower the voltage applied to the second electrode 61b in a state where the voltage applied to the first electrode 61a is maintained to be constant when the voltage applied to the liquid-crystal lens 62 is adjusted.

Since the printed circuit board camera 60 with this configuration is fixed to the X-axis moving carriage 34 along with the head holding device 40 as described above, when the head holding device 40 suctions the electronic component, the printed circuit board camera 60 is positioned above the component supply position Ps of the component supply device 20. Due to the movement control of the component transfer device 30, the printed circuit board camera 60 is caused to move such that the plurality of feeders 21 of the component supply device 20 are brought into the visual field of the printed circuit board camera 60, and the printed circuit board camera 60 can image each of the electronic components at the component supply position Ps. Details of distance measurement using the printed circuit board camera 60 will be described later.

The control device 70 is mainly configured to include a CPU, various memories, and control circuits, and controls the operation of the mounting head 44 based on the image data acquired from the imaging operations of the component camera 50 and the printed circuit board camera 60. As illustrated in Fig. 2, the control device 70 is configured such that an input and output interface 75 is connected to a mounting control section 71, an image processing section 72, a distance measurement section 74, and a memory section 73 via a bus. A motor control circuit 76 and an imaging control circuit 77 are connected to the input and output interface 75.

The mounting control section 71 controls the position of the mounting head 44 or the operation of the suction mechanism via the motor control circuit 76. More specifically, the mounting control section 71 receives information output from a plurality of various sensors which are provided in the component mounting machine 1, or the results of various recognition processes. The mounting control section 71 transmits a control signal to the motor control circuit 76 based on a control program stored in the memory section 73, information from various sensors, and the results of image processes or recognition processes. The image processing section 72 acquires the image data from the imaging operations of the component camera 50 and the printed circuit board camera 60 via the imaging control circuit 77, and executes image processes corresponding to the purpose of use. The examples of the image processes include processes such as the binarization of image data, filtering, and color extraction.

The memory section 73 is an optical drive device such as a hard disk, a flash memory, or the like. The memory section 73 stores a control program executed to operate the component mounting machine 1; image data that is transmitted from the component camera 50 and the printed circuit board camera 60 to the control device 70 via a bus or communication cables; temporary data of a process performed by the image processing section 72; a lens characteristic used in a distance measurement process; and the like.

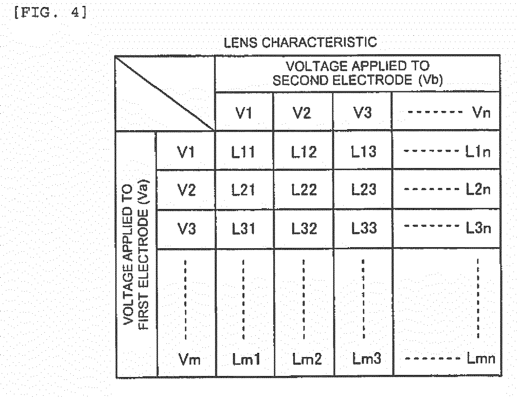

The lens characteristic referred to here represents a relationship between a voltage applied to the liquid-crystal lens 62 and the distance between a target object and the printed circuit board camera 60. In the embodiment, as illustrated in Fig. 4, the lens characteristic of the liquid-crystal lens 62 is mapped to illustrate the distances between the target objects and the printed circuit board camera 60 which are determined by the voltage Va applied to the first electrode 61a and the voltage Vb applied to the second electrode 61b. The distance between the target object and the printed circuit board camera 60 correlates to the focal length that is changed depending on the amount of voltage applied to the liquid-crystal lens 62. For this reason, the lens characteristic may represent a relationship between the applied voltage and the focal length.

The distance measurement section 74 measures the distance to a target object using the printed circuit board camera 60. Specifically, first, the distance measurement section 74 receives the value of a voltage applied to the liquid-crystal lens 62 when the focusing control section 65 brings the target object into focus. Subsequently, the distance measurement section 74 acquires the lens characteristic that is stored in the memory section 73 in advance. The distance measurement section 74 measures the distance to the target object based on the received value of the applied voltage and the lens characteristic. When the lens characteristic represents the relationship between the applied voltage and the focal length, the distance measurement section 74 may measure the distance between the target object and the printed circuit board camera 60 based on the focal length. The "distance between the target object and the printed circuit board camera 60" represents the distance between the surface of the target object and an imaging surface of the imaging element 63.

The input and output interface 75 converts data format or adjusts signal intensity while being interposed between the CPU or the memory section 73 and the control circuits 76 and 77. The motor control circuit 76 controls the Y-axis servo motor 33, X-axis servo motor 35, Z-axis servo motor 43, and θ-axis servo motor 46, based on a control signal from the mounting control section 71. Accordingly, the servo motors are controlled such that the mounting head 44 is positioned in the X-, Y-, and Z-axis directions, and the suction nozzle 45 is positioned at a predetermined angle. The motor control circuit 76 can transmit an imaging control signal to the component camera 50 based on information regarding the position of each of the X-, Y-axis, and Z-axis motors (control target), and the like. Accordingly, for example, the component camera 50 images a target object at a proper timing when the suction nozzle 45 passes through a pre-set position.

The imaging control circuit 77 controls imaging operations of the component camera 50 and the printed circuit board camera 60 based on an imaging control signal from the CPU of the control device 70 or the motor control circuit 76. The imaging control circuit 77 acquires image data from the imaging operation of the component camera 50 and the printed circuit board camera 60, and stores the image data in the memory section 73 via the input and output interface 75. In addition, in response to demand of the distance measurement section 74, the imaging control circuit 77 transmits a control signal to the focusing control section 65 of the printed circuit board camera 60 such that the liquid-crystal lens 62 brings a target object into focus. When the focusing control section 65 brings the target object into focus, the value of a voltage applied to the liquid-crystal lens 62 is acquired, and is output to the distance measurement section 74.

### (Measurement of Distance to Circuit Board As Target Object)

The measurement of the distance to the circuit board B as a target object in the component mounting machine 1 will be described with reference to the drawings. In the distance measurement, as described above, the target object is the circuit board B that is transported, positioned at the predetermined position, and held by the board conveyance device 10. That is, when mounting the electronic components on the circuit board B, the component mounting machine 1 measures the distance between the circuit board B and the printed circuit board camera 60, and performs mounting operations using the measurement result.

More specifically, first, the board conveyance device 10 transports the circuit board B to the predetermined position, and holds the circuit board B by positioning and clamping the circuit board B. The control device 70 drives each of the X-, Y-axis, and Z-axis motors such that a distal end portion of the suction nozzle 45 held by the mounting head 44 moves to the component supply position Ps of the component supply device 20. When the suction mechanism of the head holding device 40 operates, the distal end portion of the suction nozzle 45 suctions the electronic component which is supplied by the component supply device 20.

Subsequently, the mounting head 44 is caused to move to a coordinate position determined on the circuit board B due to the operation of the component transfer device 30. At this time, the mounting head 44 moves through the visual field of the component camera 50 which is present above the component camera 50. The component camera 50 images the electronic component based on a control signal transmitted from the control device 70, and transmits image data to the control device 70. The control device 70 recognizes a suction state such as the position and the angle of the electronic component relative to the suction nozzle 45 based on the acquired image data.

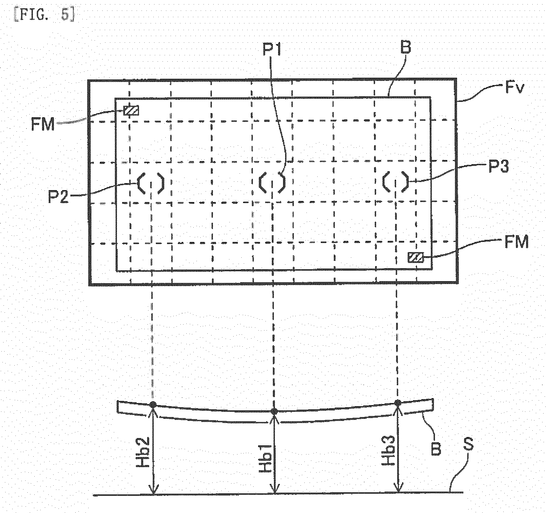

Subsequently, the printed circuit board camera 60 moves in such a way that the circuit board B is brought into a visual field Fv, and the printed circuit board camera 60 images the circuit board B based on a control signal transmitted from the control device 70, and transmits image data to the control device 70. The image processing section 72 performs image processing of the acquired image data such that the control device 70 recognizes the positions of board marks FM (refer to Fig. 5) at two corners of the circuit board B. The control device 70 recognizes a clamped state of the circuit board B based on a positional relationship between the two board marks FM. The control device 70 performs correction in the control of mounting operations according to the control program that is stored in advance, based on the clamped state of the circuit board B.

When the circuit board B is imaged, concurrently, the component mounting machine 1 calculates the height (a printed circuit board height Hb) of the circuit board B, and acquires a deformation state of the circuit board B. Specifically, when the control device 70 transmits a control signal to the printed circuit board camera, the focusing control section 65 adjusts a voltage applied to the liquid-crystal lens 62 such that the printed circuit board camera 60 brings the circuit board (target object which is present in the visual field Fv) B into focus. At this time, the focusing control section 65 performs focusing a region P1 as a reference, with the region P1 positioned in a center region of the visual field Fv. The control device 70 receives the values of the voltages Va and Vb which are respectively applied to the first electrode 61a and the second electrode 61b of the liquid-crystal lens 62 when the focusing control section 65 brings the region P1 into focus .

The distance measurement section 74 measures the distance to the circuit board B (the region P1) (target object) based on the received values of the applied voltages Va and Vb corresponding to the region P1, and the lens characteristic (refer to Fig. 4). The control device 70 calculates the printed circuit board height Hb between a reference surface S of the component mounting machine 1 and the surface of the circuit board B based on the measurement result and information regarding the current position of the head holding device 40 to which the printed circuit board camera 60 is fixed.

When the focusing control section 65 brings the reference region P1 into focus, the focusing control section 65 also brings a plurality of regions P2 and P3 into focus, with the regions P2 and P3 set separately from the region P1 in a longitudinal direction of the circuit board B. Similar to the reference region P1, the distance measurement section 74 measures the distance to each of the plurality of regions P2 and P3 based on the lens characteristic, and the applied voltages Va and Vb to the liquid-crystal lens 62 when the regions P2 and P3 are brought into focus.

The control device 70 acquires a deformation state of the circuit board B based on the measurement results. As illustrated in Fig. 5, the deformation state is caused due to warping of the circuit board, and it is possible to understand a curved deformation state by measuring the distances to at least three points. In addition, it is possible to more accurately acquire a deformation state by measuring the distances to an increased number of regions. Since the deformation state of the circuit board B is acquired, it is possible to estimate the printed circuit board heights (heights from the reference surface S) of regions for which distance measurement is not performed.

When the electronic components are mounted, the control device 70 corrects the lowering position of the suction nozzle 45 corresponding to the acquired printed circuit board height Hb and the deformation state of the circuit board B. That is, the control device 70 moves the suction nozzle 45 to a proper lowering end while the amount of deformation of the circuit board B at the mounting positions of the electronic components is taken into consideration. As such, the control device 70 prevents excessive or insufficient movement of the suction nozzle 45 which is caused by a clamped state or a deformation state of the circuit board B, and improves the accuracy of the control of mounting operations.

### (Measurement of Distance to Plurality of Electronic Components As Target Objects)

The measurement of the distance to the plurality of electronic components as target objects in the component mounting machine 1 will be described with reference to the drawings. In the distance measurement, as described above, the target objects are the plurality of electronic components that are transported to the component supply positions Ps by the component supply device 20. That is, when the electronic component is suctioned, the component mounting machine 1 measures the distance between each of the plurality of electronic components and the printed circuit board camera 60, and performs suction operations using the measurement result.

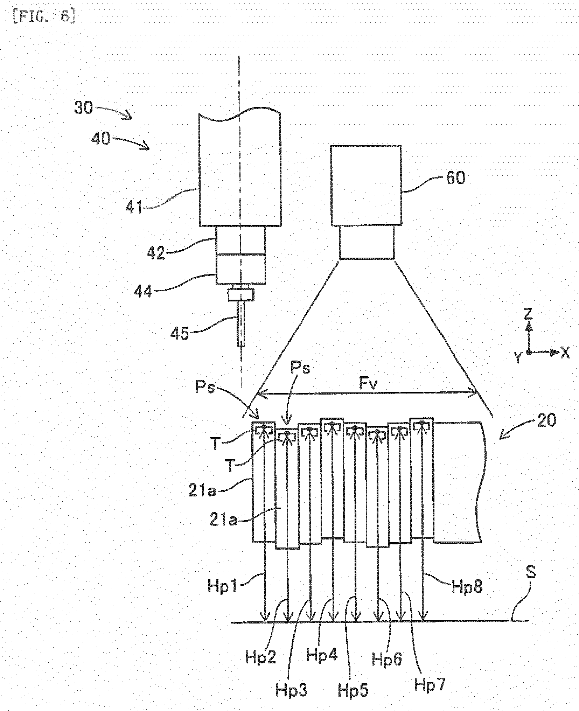

More specifically, first, the control device 70 drives each of the X-, Y-, and Z-axis motors such that the distal end portion of the suction nozzle 45 held by the mounting head 44 moves to a region above the component supply position Ps of the component supply device 20. At this time, as illustrated in Fig. 6, the printed circuit board camera 60 moves along with the head holding device 40, and can image electronic components T at a plurality of the component supply positions Ps which are present in the visual field Fv. When the focusing control section 65 receives a control signal transmitted from the control device 70, the focusing control section 65 controls the printed circuit board camera 60 such that the printed circuit board camera 60 brings the plurality of electronic components (target objects) T into focus.

At this time, the position, in which the printed circuit board camera 60 performs focusing in the visual field Fv, is designated by the following method or the like. First, image processing is performed on image data captured by the printed circuit board camera 60 at the current position, and thus the positions of the plurality of electronic components T are recognized. A region of the visual field Fv of the printed circuit board camera 60, which includes the positions of the plurality of electronic components T, is designated as the region in which focusing is performed. The image processing and the designation of region may be performed by either of the printed circuit board camera 60 or the control device 70.

When the printed circuit board camera 60 brings the plurality of electronic components T into focus, the control device 70 receives the values of the voltages Va and Vb which are respectively applied to the first electrode 61a and the second electrode 61b of the liquid-crystal lens 62 when the focusing control section 65 brings the plurality of electronic components T into focus. The distance measurement section 74 measures the distance between each of the plurality of electronic components T which are target objects and the printed circuit board camera 60 based on the values of the applied voltages Va and Vb and the lens characteristic (refer to Fig. 4). Since the distance measurement method is same as the method by which the distance to the circuit board B as a target object is measured, a detailed description thereof will be omitted.

The control device 70 calculates component heights Hp1 to Hp8 between the reference surface S of the component mounting machine 1 and the surface of each of the electronic components T, based on the measurement results and information regarding the current position of the head holding device 40 to which the printed circuit board camera 60 is fixed. The control device 70 controls the operation of suctioning the electronic components T based on the acquired component heights Hpl to Hp8. That is, in the operation of suctioning the electronic components T, the control device 70 corrects the lowering position of the suction nozzle 45 corresponding to the respective component heights Hpl to Hp8.

In other words, the control device 70 moves the suction nozzle 45 to a proper lowering end while variations in the component supply position Ps of the component supply device 20 are taken into consideration. As such, the control device 70 prevents excessive or insufficient movement of the suction nozzle 45 which is caused by an installation state of each of the feeders 21 of the component supply device 20 or the dimensions or a packaging state of each of the electronic components T, and improves the accuracy of the control of suction operations.

### (Effects of Configuration of Embodiment)

The component mounting machine 1 measures the distance between a target object (the circuit board B and the electronic component T) and the printed circuit board camera 60 using the printed circuit board camera 60 that images the circuit board B so as to read the board mark FM on the circuit board B which is a manufacturing material. That is, it is possible to use the printed circuit board camera 60 which is already built in, and thus it is possible to measure the distance to the target object which is usable for the control of mounting operations or suction operations without additionally installing a device such as a sensor. As a result, the component mounting machine 1 can improve the control accuracy by controlling mechanical operations using the measurement result.

The focusing control section 65 brings the plurality of regions P1 to P3 on the circuit board B into focus, and the distance measurement section 74 measures the distance to each of the plurality of regions P1 to P3 on the circuit board B. Accordingly, it is possible to acquire a deformed shape of the circuit board B based on the measurement results. As in the embodiment, it is possible to acquire a plurality of printed circuit board heights Hbl to Hb3 via a series of measurement operations in which a voltage applied to the liquid-crystal lens 62 is changed in the same visual field Fv. As a result, even if the distances to a plurality of locations are measured, it is possible to efficiently perform the distance measurement.

The control device 70 acquires a deformation state of the circuit board B based on the distance to each of the plurality of regions P1 to P3 which is measured using the printed circuit board camera 60. Accordingly, the control device 70 can control the upward and downward movement of the suction nozzle 45 with high accuracy during mounting operations. As a result, it is possible to prevent the occurrence of a mounting defect which is caused by the withdrawal or the excessive pushing of the electronic component corresponding to different warping of the circuit boards B. It is possible to improve the quality of a circuit board product, and to prevent the suction nozzle 45 from being damaged.

The component heights of the electronic components T at the component supply positions Ps of the component supply device 20 may be different depending on an installation state of each of the feeders 21, or the dimensions or a packaging state of each of the electronic components T. In this case, the difference in the component heights affects the operation of suctioning the electronic components T. In contrast, in the embodiment, the distances to the plurality of electronic components T are measured, and the component heights Hpl to Hp8 of the electronic components T are calculated based on the measurement results. Since it is possible to control the lowering end of the suction nozzle 45 corresponding to the component heights Hpl to Hp8, it is possible to improve the control of suction operations.

In the embodiment, the liquid-crystal lens 62 is used as a varifocal lens . The examples of the varifocal lens include a liquid lens and a liquid-crystal lens. A temperature error or the like is less likely to occur in the liquid-crystal lens compared to the liquid lens, and the liquid-crystal lens is advantageous in terms of durability. Since the liquid-crystal lens has a high focus change speed, it is possible to reduce the amount of time required to perform focusing. Since the liquid-crystal lens has no or minor hysteresis in focal length which is associated with the boosting and the lowering of the applied voltage, it is possible to improve measurement accuracy. For this reason, the use of the liquid-crystal lens is particularly effective in the distance measurement via the mapping as in the embodiment.

### <Modification to Embodiment>

In the embodiment, the focusing control section 65, the memory section 73, and the distance measurement section 74 which are used to measure the distance to a target object are provided in the printed circuit board camera 60 or the control device 70. In contrast, for example, the printed circuit board camera 60 may be configured to include the memory section and the distance measurement section. Since the printed circuit board camera 60 acts as a distance measurement device, it is possible to reduce the processing load of the control device 70 and the amount of communication with the control device 70.

The map representative of the distance between a target object and the printed circuit board camera 60 is exemplified as the lens characteristic which is stored in the memory section 73 in advance. In contrast, in addition to the map, the lens characteristic may be an expression that represents a relationship between an applied voltage and the distance between a target object and the camera. In this configuration, the same effects are obtained.

In the embodiment, the component mounting machine 1 which mounts the electronic components T on the circuit board B is exemplified as a manufacturing equipment. In contrast, the following equipment may be adopted as a manufacturing equipment insofar as the equipment can image manufacturing materials and control mechanical operations : a screen printer in a production line for the same circuit board product as in the embodiment, an assembly machine that assembles components to an assembled body, and the like. In this case, the circuit board, cream solder, a screen mask, the assembly components, the assembled body, and the like are equivalent to manufacturing materials, and a distance measurement device can be configured such that an imaging camera has a varifocal lens and an imaging element. In this configuration, it is possible to control printing operations or assembly operations while the distance to a target object is taken into consideration, and to improve accuracy.

The liquid-crystal lens 62 with the first electrode 61a and the second electrode 61b is exemplified as a varifocal lens. The liquid-crystal lens has various characteristics including the number of electrodes depending on the purpose of use or the like. Also in this case, as in the embodiment, it is possible to measure the distance to a target object by acquiring lens characteristics in advance. A liquid lens may be used as a varifocal lens.

### Reference Signs List

1: component mounting machine (manufacturing equipment), 10: board conveyance device, 20: component supply device, 30: component transfer device, 50: component camera, 60: printed circuit board camera, 62: liquid-crystal lens, 62a: first electrode, 62b: second electrode, 63: imaging element, 65: focusing control section, 70: control device, 73: memory section, 74: distance measurement section, B: circuit board, Ps: component supply position, T: electronic component, Hb1 to Hb3: printed circuit board height, Hpl to Hp8: component height

## Claims

1. A manufacturing equipment (1) including:
a head holding device (40) with a mounting head (44),
a camera (60) fixed to the head holding device (40) to move along therewith, and provided to be able to image a manufacturing material (T, B), and
a control device (70) configured to control manufacturing based on information contained in an image captured by the camera (60), and a control program stored in advance,
wherein the camera (60) comprises:
a varifocal lens (62) changing a focal length corresponding to a voltage applied thereto, and an imaging element (63) configured to convert light transmitted through the varifocal lens (62) into an electric signal,
a focusing control section (65) configured to cause the varifocal lens (62) to bring a target object (T, B) into focus by adjusting the voltage applied to the varifocal lens (62) based on the electric signal of the imaging element (63); and
wherein the control device (70) comprises:
a memory section (73) configured to store a lens characteristic in advance which represents a relationship between the voltage applied to the varifocal lens (62) and the distance between the target object (T, B) and the camera (60); and
a distance measurement section (74) configured to measure the distance to the target object (T, B) based on the voltage applied to the varifocal lens (62) when the focusing control section (65) brings the target object (T, B) into focus, and the lens characteristic,
wherein the manufacturing equipment (1) is a component mounting machine configured to mount electronic components (T) on a printed circuit board (B),
wherein the manufacturing equipment (1) comprises a component supply device (20) configured to supply electronic components (T) to be mounted on a circuit board (B),
wherein the mounting head (44) of the head holding device (40) is adapted to hold a suction nozzle (45) configured to suction electronic components (T) supplied by the component supply device (20), and
**characterized in that**
the control device (70) is configured to measure the distance between the camera (60) and the electronic components (T) as target objects provided at component supply positions (Ps) on the component supply device (20), and is configured to control an operation of suctioning the electronic components (T) based on a component height (Hp1-Hp8) acquired from the measurement.

2. The manufacturing equipment (1) according to claim 1,
wherein the focusing control section (65) is configured to bring a plurality of regions (P1-P3) on a circuit board as a target object (B) into focus, and
wherein the distance measurement section (74) is configured to measure the distance to each of the plurality of regions (P1-P3) based on the voltage applied to the varifocal lens (62) when the plurality of regions (P1-P3) are brought into focus, and the lens characteristic.

3. The manufacturing equipment (1) according to claim 2,
wherein the manufacturing equipment (1) is configured for manufacturing a circuit board product (B) with a plurality of electronic components (T) being disposed thereon,
wherein the camera (60) is a printed circuit board camera configured to image the printed circuit board (B) as the target object, and
wherein the control device (70) is configured to acquire a deformation state of the printed circuit board (B) based on the distance to each of the plurality of regions (P1-P3) on the printed circuit board (B) which is measured by the distance measurement section (74).

4. The manufacturing equipment (1) according to any one of claims 1 to 3,
wherein the varifocal lens (62) is a liquid-crystal lens which is configured such that a liquid crystal layer is disposed between two electrodes (62a, 62b).

## Patentansprüche

1. Herstellungsanlage (1), die enthält:
eine Einrichtung (40) zum Halten eines Kopfes mit einem Montage-Kopf (44),
eine Kamera (60), die an der Einrichtung (40) zum Halten eines Kopfes befestigt ist und sich zusammen mit ihr bewegt, und die in der Lage ist, ein Bild eines Herstellungs-Materials (T, B) zu erzeugen, sowie
eine Steuerungs-Einrichtung (70), die so eingerichtet ist, dass sie Herstellung auf Basis von Informationen, die in einem mit der Kamera (60) aufgenommenen Bild enthalten sind, sowie eines Steuerungs-Programms steuert, das im Voraus gespeichert wird,
wobei die Kamera (60) umfasst:
ein Varioobjektiv (62), das eine Brennweite entsprechend einer daran angelegten Spannung ändert, sowie ein Bilderzeugungs-Element (63), das so eingerichtet ist, dass es durch das Varioobjektiv (62) durchgelassenes Licht in ein elektrisches Signal umwandelt,
einen Teilabschnitt (65) für Fokussier-Steuerung, der so eingerichtet ist, dass er das Varioobjektiv (62) veranlasst, auf ein Ziel-Objekt (T, B) zu fokussieren, indem er die an das Varioobjektiv (62) angelegte Spannung auf Basis des elektrischen Signals des Bilderzeugungs-Elementes (63) reguliert; und
wobei die Steuerungs-Einrichtung (70) umfasst:
einen Speicher-Teilabschnitt (73), der so eingerichtet ist, dass er im Voraus eine Objektiv-Charakteristik speichert, die eine Beziehung zwischen der an das Varioobjektiv (62) angelegten Spannung und der Entfernung zwischen dem Ziel-Objekt (T, B) und der Kamera (60) repräsentiert;
einen Teilabschnitt (74) für Entfernungs-Messung, der so eingerichtet ist, dass er die Entfernung zu dem Ziel-Objekt (T, B) auf Basis der an das Varioobjektiv (62) angelegten Spannung beim Fokussieren auf das Ziel-Objekt (T, B) durch den Teilabschnitt (65) für Fokussier-Steuerung und der Objektiv-Charakteristik misst,
wobei die Herstellungsanlage (1) eine Maschine zum Montieren von Bauteilen ist, die so eingerichtet ist, dass sie elektronische Bauteile (T) auf einer Leiterplatte (B) montiert,
wobei die Herstellungsanlage (1) eine Einrichtung (20) für Zufuhr von Bauteilen umfasst, die zum Zuführen von auf einer Leiterplatte (B) zu montierenden elektronischen Bauteilen (T) eingerichtet ist,
der Montage-Kopf (44) der Einrichtung (40) zum Halten eines Kopfes so ausgeführt ist,
dass er eine Saugdüse (45) hält, die zum Ansaugen durch die Einrichtung (20) zur Zufuhr von Bauteilen zugeführter elektronischer Bauteile (T) eingerichtet ist, und
**dadurch gekennzeichnet, dass**
die Steuerungs-Einrichtung (70) so eingerichtet ist, dass sie die Entfernung zwischen der Kamera (60) und den elektronischen Bauteilen (T) als Ziel-Objekten misst, die sich an Positionen (Ps) zum Zuführen von Bauteilen an der Einrichtung (20) für Zufuhr von Bauteilen befinden, und so eingerichtet ist, dass sie einen Vorgang des Ansaugens der elektronischen Bauteile (T) auf Basis einer mit der Messung ermittelten Bauteil-Höhe (Hp1-Hp8) steuert.

2. Herstellungsanlage (1) nach Anspruch 1,
wobei der Teilabschnitt (65) für Fokussier-Steuerung so eingerichtet ist, dass er auf eine Vielzahl von Bereichen (P1-P3) auf einer Leiterplatte als einem Ziel-Objekt (B) fokussiert, und
der Teilabschnitt (74) für Entfernungs-Messung so eingerichtet ist, dass er die Entfernung zu jedem der Vielzahl von Bereichen (P1-P3) auf Basis der an das Varioobjektiv (62) beim Fokussieren auf die Vielzahl von Bereichen (P1-P3) sowie der Objektiv-Charakteristik misst.

3. Herstellungsanlage (1) nach Anspruch 2,
wobei die Herstellungsanlage (1) zum Herstellen eines Leiterplatten-Erzeugnisses (B) mit einer Vielzahl daran angeordneter elektronischer Bauteile (T) eingerichtet ist,
die Kamera (60) eine Leiterplatten-Kamera ist, die zum Erzeugen eines Bildes der Leiterplatte (B) als dem Ziel-Objekt eingerichtet ist, und
die Steuerungs-Einrichtung (70) so eingerichtet ist, dass sie einen Verformungs-Zustand der Leiterplatte (B) auf Basis der Entfernung zu jedem der Vielzahl von Bereichen (P1-P3) an der Leiterplatte (B) ermittelt, die durch den Teilabschnitt (74) für Entfernungs-Messung gemessen wird.

4. Herstellungsanlage (1) nach einem der Ansprüche 1 bis 3,
wobei das Varioobjektiv (62) ein Flüssigkristall-Objektiv ist, das so eingerichtet ist, dass eine Flüssigkristall-Schicht zwischen zwei Elektroden (62a, 62b) angeordnet ist.

## Revendications

1. Équipement de production (1) comprenant :
un dispositif de maintien de tête (40) avec une tête de montage (44),
une caméra (60) fixée sur le dispositif de maintien de tête (40) pour se déplacer avec celui-ci et disposée de manière à pouvoir réaliser des images d'un matériau de production (T,B), et
un dispositif de commande (70) conçu pour commander la production sur la base d'informations contenues dans une image capturée par la caméra (60), et un programme de commande enregistré à l'avance,
dans lequel la caméra (60) comprend :
une lentille à focale variable (62) changeant de longueur focale en fonction d'une tension qui lui est appliquée, et un élément d'imagerie (63) conçu pour convertir la lumière transmise à travers la lentille à focale variable (62) en un signal électrique,
une section de commande de mise au point (65) conçue pour faire effectuer par la lentille à focale variable (62) la mise au point sur un objet cible (T, B) en ajustant la tension appliquée à la lentille à focale variable (62) en fonction du signal électrique de l'élément d'imagerie (63) ; et
dans lequel le dispositif de commande (70) comprend :
une section de mémoire (73) conçue pour enregistrer à l'avance une caractéristique de lentille qui représente une relation entre la tension appliquée à la lentille à focale variable (62) et la distance entre l'objet cible (T, B) et la caméra (60) ; et
une section de mesure de distance (74) conçue pour mesurer la distance à l'objet cible (T, B) sur la base de la tension appliquée à la lentille à focale variable (62) lorsque la section de commande de mise au point (65) effectue la mise au point sur l'objet cible (T, B), et de la caractéristique de lentille,
dans lequel l'équipement de production (1) est une machine de montage de composants conçue pour monter des composants électroniques (T) sur une carte de circuit imprimé (B),
dans lequel l'équipement de production (1) comprend un dispositif d'amenée de composants (20) conçu pour amener des composants électroniques (T) destinés à être montés sur une carte de circuit imprimé (B),
dans lequel la tête de montage (44) du dispositif de maintien de tête (40) est conçue pour maintenir une buse d'aspiration (45) configurée pour aspirer des composants électroniques (T) amenés par le dispositif d'amenée de composants (20), et
**caractérisé en ce que**
le dispositif de commande (70) est conçu pour mesurer la distance entre la caméra (60) et les composants électroniques (T) en tant qu'objets cibles disposés au niveau de positions d'amenée de composants (Ps) sur le dispositif d'amenée de composants (20), et est conçu pour commander une opération d'aspiration des composants électroniques (T) en fonction d'une hauteur de composant (Hp1-Hp8) obtenue par la mesure.

2. Équipement de production (1) selon la revendication 1,
dans lequel la section de commande de mise au point (65) est conçue pour effectuer la mise au point sur une pluralité de zones (P1-P3) sur une carte de circuit imprimé en tant qu'objet cible (B), et
dans lequel la section de mesure de distance (74) est conçue pour mesurer la distance à chacune de la pluralité des zones (P1-P3) sur la base de la tension appliquée à la lentille à focale variable (62) lorsque la mise au point est effectuée sur la pluralité de zones (P1-P3), et de la caractéristique de lentille.

3. Équipement de production (1) selon la revendication 2,
dans lequel l'équipement de production (1) est conçu pour fabriquer un produit de carte de circuit imprimé (B) sur lequel une pluralité de composants électroniques (T) sont disposés,
dans lequel la caméra (60) est une caméra pour carte de circuit imprimé conçue pour réaliser des images de la carte de circuit imprimé (B) en tant qu'objet cible, et
dans lequel le dispositif de commande (70) est conçu pour acquérir un état de déformation de la carte de circuit imprimé (B) en fonction de la distance à chacune de la pluralité des zones (P1-P3) sur la carte de circuit imprimé (B), qui est mesurée par la section de mesure de distance (74).

4. Équipement de production (1) selon l'une quelconque des revendications 1 à 3,
dans lequel la lentille à focale variable (62) est une lentille à cristaux liquides qui est conçue de sorte qu'une couche de cristaux liquides soit disposée entre deux électrodes (62a, 62b).
